# EUROPEAN PATENT SPECIFICATION

(11) **EP 0 434 153 B1**
(45) Date of publication and mention of the grant of the patent: **16.03.1994**
(21) Application number: 90203348.9
(22) Date of filing: 17.12.1990
(51) Int. Cl.: H01L 21/225, H01L 21/265, H01L 21/331

(54) **A method of making a semiconductor device with a npn bipolar transistor**
Verfahren zur Herstellung einer Halbleiteranordnung mit einem NPN Bipolartransistor
Procédé de fabrication d'un composant semiconducteur comprenant un transistor bipolaire NPN

(30) Priority: 21.12.1989 US 456014
(43) Date of publication of application: 26.06.1991
(73) Proprietor: Philips Electronics N.V., 5621 BA Eindhoven (NL)
(72) Inventor: van Schravendijk, Bart, NL-5656 AA Eindhoven (NL)
(74) Representative: Rensen, Jan Geert

(56) References cited:
- EP-A- 0 029 548
- EP-A- 0 208 577
- EP-A- 0 255 882
- US-A- 4 542 580
- RESEARCH DISCLOSURE. no. 278, June 1987, HAVANT GB pages 397 - 399; "Polysilicon diffusion source bipolar transistor "
- PATENT ABSTRACTS OF JAPAN vol. 10, no. 213 (E-422)(2269) 25 July 1986, & JP-A-61 051912 (NEC CORP.) 14 March 1986,
- PATENT ABSTRACTS OF JAPAN vol. 8, no. 81 (E-238)(1518) 13 April 1984, & JP-A-59 000960 (MATSUSHITA DENSHI KOGYO K.K.) 06 January 1984,
- Proceedings of the IEEE 1988 Bipolar circuits and technology meeting 12 September 1988, MINNEAPOLIS USA pages 132 - 135; B. van SCHRAVENDIJK et al: "Thin base formation by double diffused polysilicon technology"

## Description

This invention relates to the fabrication of bipolar transistors and, more particularly, to a fabrication method that includes forming the base and emitter regions of such a transistor by outdiffusing dopants from a source layer into an underlying silicon body.

### Background of the invention

It is known to employ a doped layer as a source from which dopants are diffused into an underlying silicon body to form the base and emitter regions of a high-performance bipolar transistor. Thus, for example, the use of doped polysilicon for this purpose is described in European Patent No. 90,940.

In the aforecited and similar references, p- and n-type dopants are successively outdiffused from an ion-implanted polysilicon layer into an n-type silicon body in a two-step annealing process to form the base and emitter regions, respectively, of a bipolar transistor device. Typically, the two-step process is carried out before the polysilicon layer is patterned to define the emitter contact of the transistor. Accordingly, the polysilicon layer must usually be masked to avoid implanting selected portions thereof with p-type impurities. In that way, p-type dopants are not available in the selected portions of the polysilicon layer to be driven into respectively underlying portions of the silicon body where lightly doped n-type regions are required for forming devices such as Schottky diodes.

The aforespecified two-step annealing process is necessitated by ion channeling effects in the polysilicon layer. Thus, for example, such effects limit the depth to which a p-type dopant such as boron can be implanted in the polysilicon layer when, for example, both bipolar and metal-oxide-semiconductor (MOS) transistor devices are to be simultaneously made in a silicon wafer. If implanted too deeply, boron can penetrate an underlying layer such as a thin silicon dioxide layer which constitutes a part of the MOS devices. The electrical properties of the MOS devices and of other devices being formed can be thereby detrimentally affected.

Furthermore, due to grain boundary diffusion in polysilicon, an n-type dopant such as arsenic diffuses extremely rapidly therein. Moreover, arsenic acts to retard diffusion of boron in the polysilicon. Thus, in a one-step annealing process, rapid diffusion of arsenic relative to that of boron in the polysilicon layer can in practice actually cause arsenic to overtake the more deeply implanted boron as the dopants diffuse into the underlying silicon body. In that case, no p-type (base) region is formed in the body and the process is accordingly ineffective for making bipolar transistors. And, in fact, at least one published report states that such simultaneous outdiffusion of both boron and arsenic from polysilicon in a one-step annealing process to form base and emitter regions is not possible (see "Process and Device Related Scaling Considerations for Polysilicon Emitter Bipolar Transistors" by H. Schaber et al, Proc. IEDM 1987, pages 170-173).

Accordingly, efforts have continued by workers skilled in the art aimed at trying to devise an improved method for outdiffusing dopants from a source layer into an underlying silicon body to form the base and emitter regions of a bipolar transistor device. In particular, these efforts have been directed at attempts to formulate a device fabrication method characterized by a one-step annealing process to accomplish outdiffusion. It was recognized that these efforts, if successful, could simplify and thereby lower the cost of making high-performance bipolar transistor devices.

### Summary of the invention

According to the invention a method for making a semiconductor device with a NPN bipolar transistor comprises the steps of on
- depositing an amorphous silicon layer on an n-type monocrystalline silicon layer in which a base region and an emitter region of the transistor are to be formed;
- ion implanting a p-type dopant into said amorphous silicon layer to establish a dopant concentration profile that lies at least substantially within said amorphous silicon layer and has a peak concentration that is relatively deep within said amorphous silicon layer;
- ion implanting an n-type dopant into said amorphous silicon layer to establish a dopant concentration profile that lies at least substantially within said amorphous silicon layer and has a peak concentration that is relatively shallow within said amorphous silicon layer;
- patterning said implanted amorphous silicon layer; and subsequently
- annealing the layered structure to cause said p-type and said n-type dopant to simultaneously diffuse from said amorphous silicon layer to form in said monocrystalline silicon layer a relatively deep p-type base region and a relatively shallow n-type emitter region.

In accordance with a specific illustrative embodiment of the principles of the present invention, a layer of amorphous silicon is employed as a diffusion source for forming base and emitter regions in an underlying monocrystalline silicon body. First, a p-type dopant such as boron is implanted into the entirety of the layer of amorphous silicon. The peak concentration of the dopant is established at a relatively deep level in the amorphous layer. Subsequently, an n-type dopant such as arsenic is implanted into the entirety of the amorphous silicon layer to establish the peak concentration of the arsenic dopant at a more shallow level above that of the boron. The doped amorphous silicon layer is then patterned to define the emitter contact of a bipolar transistor device.

Next, the doped patterned amorphous silicon is subjected to a one-step annealing process. During this process, outdiffusion of the implanted dopants from the amorphous silicon occurs. In particular, the dopants are thereby driven into an n-type region of the underlying silicon body. A buried p-type base region and an n⁺-type emitter region adjoining and above the base region are thereby formed in the n-type region. At the same time, the amorphous silicon is converted to an n⁺-type polysilicon emitter contact, and all the dopants are activated.

It is noted that it is known per se from Research Disclosure, No. 278, June 1987, pages 397-399 and from US patent 4.542.580 to form the base and emitter of a NPN bipolar transistor by outdiffusion of dopants from a diffusion source layer into an underlying semiconductor body in a single diffusion step. In both these cases however a continuous layer of silicon is used as a diffusion source and either the silicon layer or the underlying semiconductor body is masked in order to prevent dopant to penetrate at areas where this is nor desired.

### Brief description of the drawing

A complete understanding of the present invention and of the above and other features and advantages thereof will be apparent from the detailed description presented below in conjunction with the accompanying drawing, not drawn to scale, in which:
Fig. 1 is a cross-sectional representation of a portion of a priorly known integrated-circuit structure;
Fig. 2 shows an amorphous silicon layer deposited on the top surface of the Fig. 1 structure in accordance with the principles of the present invention;
Fig. 3 depicts concentration profiles for dopants implanted into the amorphous layer shown in Fig. 2;
Fig. 4 illustrates the Fig. 2 structure after the doped amorphous layer is patterned;
Fig. 5 shows the concentration profiles of the implanted dopants after the annealing process;
Fig. 6 depicts the Fig. 4 structure after the one-step annealing process of the present invention;
and Fig. 7 represents a complete bipolar transistor device made in accordance with the principles of the present invention.

### Detailed description

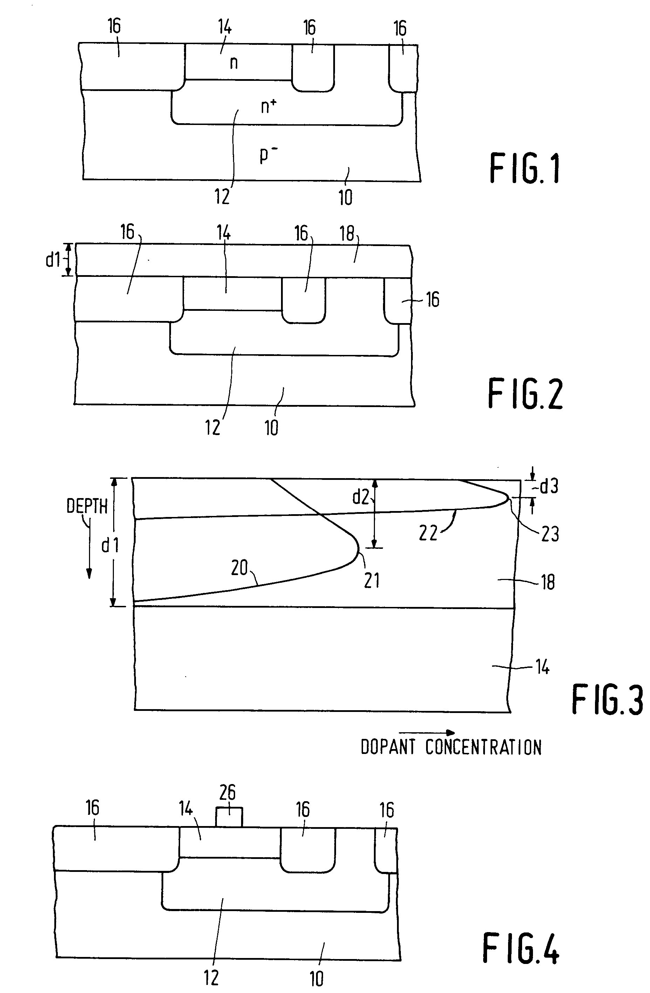

Fig. 1 shows a portion of a partially fabricated conventional integrated-circuit structure defined in a semiconductor wafer made of silicon. In particular, the depicted portion constitutes a part of an illustrative npn bipolar transistor device. In practice, multiple other such transistors as well as, for example, associated MOS transistors and other devices such as Schottky diodes would be batch fabricated in the same wafer, as is well known in the art.

By way of example, the conventional structure shown in Fig. 1 comprises a p⁻-type monocrystalline silicon substrate 10 having a buried n⁺-type layer 12 formed therein. As indicated in Fig. 1, a portion of the layer 12 extends to the surface of the structure to provide a region on which a collector contact will be subsequently formed.

The standard arrangement represented in Fig. 1 also includes an n-type epitaxial layer 14 and conventional recessed isolation regions 16 each made of silicon dioxide. In the final transistor device, a lower portion of the layer 14 will form the collector thereof. In accordance with the principles of the present invention, surface portions of the n-type layer 14 will be simultaneously doped in a one-step annealing process to form base and emitter regions therein, as described in detail later below.

In accordance with the invention, a unique diffusion source is formed on the top surface of the conventional structure shown in Fig. 1. Specifically, as indicated in Fig. 2, a layer 18 comprising amorphous silicon is deposited on the entire top surface of the previously described structure. Illustratively, the layer 18 is deposited in a conventional process that comprises low pressure chemical vapor deposition by pyrolysis of silane. By way of example, the thickness d1 of the layer 18 is selected to be approximately 0.40 micrometers.

Next, in accordance with the principles of the present invention, the entire extent of the layer 18 (Fig. 2) is successively implanted with p- and n-type dopants in a maskless process. Thus, for example, boron and arsenic ions are introduced into the depicted layer. In particular, the implantations are carried out to achieve concentration profiles of the type represented in Fig. 3.

Illustratively, boron at a concentration of about 1 x 10¹⁵ ions per centimeter square at an energy of approximately 75,000 electron volts is first implanted into the amorphous silicon layer 18. Significantly, due to the lack of ion channeling in amorphous silicon, the entire distribution of the boron implant is designed to and in fact does occur relatively deep within the amorphous silicon layer 18 with no penetration of underlying layers. In one particular illustrative case, the dopant concentration profile of the implanted boron ions appears approximately as represented in Fig. 3 by curve 20. The peak 21 of the depicted concentration profile 20 is relatively deep in the layer 18 at a distance d2 from the surface thereof. By way of example, d2 is about 0.234 micrometers.

Subsequently, arsenic at a concentration of about 7.5 x 10¹⁵ ions per centimeter square at an energy of approximately 50,000 electron volts is implanted into the amorphous silicon layer 18. The distribution of this implant also occurs entirely within the confines of the amorphous silicon layer 18, as represented in Fig. 3 by curve 22. Importantly, the peak 23 of the arsenic concentration profile 22 is shallow in the layer 18 relative to the peak 21 of the boron concentration profile 20. By way of example, the distance d3 of the peak 23 from the surface of the layer 18 is only approximately 0.032 micrometers.

In a series of conventional lithographic masking and etching steps, the doped amorphous silicon layer 18 of Fig. 2 is then patterned. After these steps, the portions of the layer 18 that remain are spaced-apart regions that will constitute emitter contacts of the bipolar transistor devices that are being fabricated in the depicted structure. One such remaining portion 26 is shown in Fig. 4.

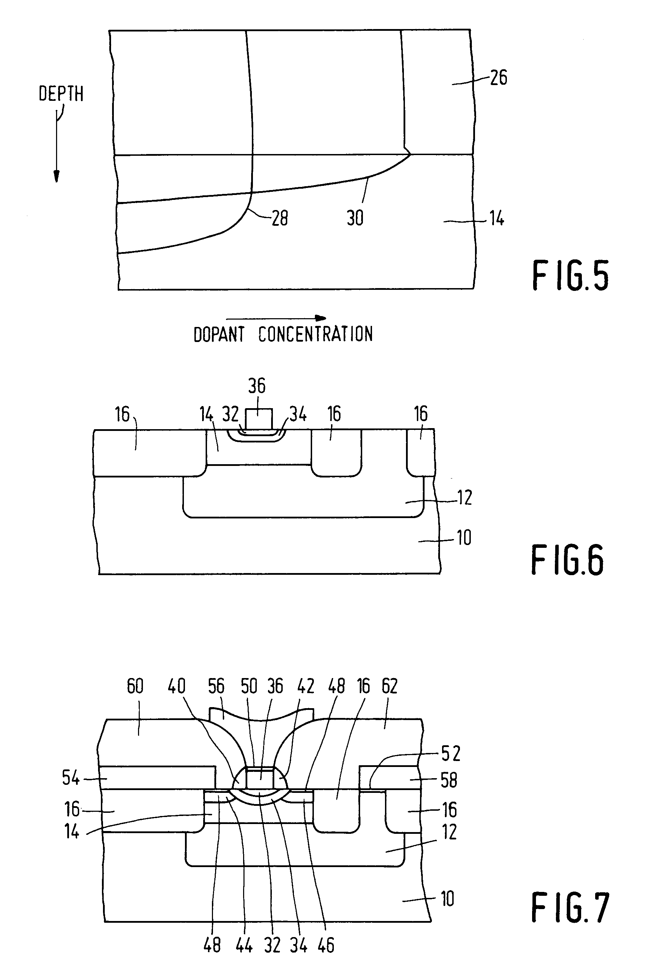

Next, the depicted structure including the doped amorphous silicon portion 26 of Fig. 4 is annealed in a one-step process. Illustratively, annealing is carried out at about 920 degrees Celsius in nitrogen for about 20 minutes. As a result, boron and arsenic ions diffuse from the portions 26 into surface regions of the underlying n-type layer 14. The concentration profiles of these dopants after annealing are indicated in Fig. 5, where curves 28 and 30 represent the boron and arsenic profiles, respectively. In this way, a relatively deep p-type boron base region 34 and an adjoining relatively shallow n⁺-type arsenic emitter region 32 are formed in the layer 14, as shown in Fig. 6.

During the single annealing step, the doped amorphous silicon portion 26 of Fig. 4 is converted to n⁺-type polysilicon. This converted portion, which is designated by reference numeral 36 in Fig. 6, constitutes the emitter contact of the herein-specified bipolar device. Also, during the one-step annealing process, all dopants in the structure are activated.

In straightforward ways well known in the art, the structure shown in Fig. 6 is then further processed to form a complete device. A simplified schematic representation of such a complete device is illustrated in Fig. 7.

By way of example, the structure of Fig. 7 includes silicon dioxide spacer elements 40 and 42 along the sides of the emitter contact 36 and p⁺-type regions 44 and 46 that contact the base region 34. Also, the depicted illustrative structure comprises metal silicide regions 48, 50 and 52 that constitute base, emitter and collector contacts, respectively. In turn, conductive interconnect elements 54, 56 and 58 respectively contact the regions 48, 50 and 52 and are electrically insulated from each other by dielectric regions 60 and 62. As is well known, the elements 54, 56 and 58 provide instrumentalities by means of which the bipolar transistor can be connected to other devices in the depicted integrated-circuit structure and to other associated circuitry.

Thus, in accordance with the particular illustrative fabrication procedure described in detail herein, doped amorphous silicon is utilized as a diffusion source for making a bipolar transistor device. In particular, the source is used in a one-step annealing process to simultaneously form base and emitter regions of the device.

## Claims

1. A method of making a semiconductor device with a NPN bipolar transistor comprising the steps of:
- depositing an amorphous silicon layer on an n-type monocrystalline silicon layer in which a base region and an emitter region of the transistor are to be formed;
- ion implanting a p-type dopant into said amorphous silicon layer to establish a dopant concentration profile that lies at least substantially within said amorphous silicon layer and has a peak concentration that is relatively deep within said amorphous silicon layer;
- ion implanting an n-type dopant into said amorphous silicon layer to establish a dopant concentration profile that lies at least substantially within said amorphous silicon layer and has a peak concentration that is relatively shallow within said amorphous silicon layer;
- patterning said implanted amorphous silicon layer; and subsequently
- annealing the layered structure to cause said p-type and said n-type dopant to simultaneously diffuse from said amorphous silicon layer to form in said monocrystalline silicon layer a relatively deep p-type base region and a relatively shallow n-type emitter region.

2. A method as in Claim 1 in which said amorphous silicon layer is patterned to define the emitter contact region of said transistor device.

3. A method as in Claim 2 wherein, after annealing, said emitter contact region comprises an n⁺-type polysilicon contact.

4. A method as in Claim 3 wherein said p-type dopant comprises boron.

5. A method as in Claim 4 wherein boron is implanted at a concentration of approximately 1 x 10¹⁵ ions per centimeter square at an energy of about 75,000 electron volts.

6. A method as in Claim 5 wherein said n-type dopant comprises arsenic.

7. A method as in Claim 6 wherein arsenic is implanted at a concentration of approximately 7.5 x 10¹⁵ ions per centimeter square at an energy of about 50,000 electron volts.

8. A method as in Claim 7 in which annealing is carried out at about 920 degrees Celsius in nitrogen for about 20 minutes.

## Patentansprüche

1. Verfahren zum Herstellen einer Halbleiteranordnung mit einem npn-Bipolartransistor, das folgende Schritte umfaßt:
- Abscheiden einer amorphen Siliziumschicht auf einer monokristallinen n-Siliziumschicht, in der ein Basisgebiet und ein Emittergebiet des Transistors geformt werden müssen,
- Ionenimplantieren eines p-Dotierungsmittels in die amorphe Siliziumschicht zum Erzeugen eines Dotierungskonzentrationsprofils, das wenigstens hauptsächlich in der amorphen Siliziumschicht liegt und eine Spitzenkonzentration hat, die verhältnismäßig tief in die amorphe Siliziumschicht hineingeht,
- Ionenimplantieren eines n-Dotierungsmittels in die amorphe Siliziumschicht zum Erzeugen eines Dotierungskonzentrationsprofils, das wenigstens hauptsächlich in der amorphen Siliziumschicht liegt und eine Spitzenkonzentration hat, die in der amorphen Siliziumschicht verhältnismäßig untief ist,
- Musterbildung auf der implantierten amorphen Siliziumschicht, und anschließend
- Glühen der geschichteten Struktur, um die p- und n-Dotierungsmittel gleichzeitig aus der amorphen Siliziumschicht eindiffundieren zu lassen, und damit in der monokristallinen Siliziumschicht ein verhältnismäßig tiefes p-Basisgebiet und ein verhältnismäßig untiefes n-Emittergebiet zu bilden.

2. Verfahren nach Anspruch 1, mit dem die amorphe Siliziumschicht zum Definieren des Emitterkontaktgebiets der Transistoranordnung mit (einem) Muster(n) versehen wird.

3. Verfahren nach Anspruch 2, worin nach dem Glühen das Emitterkontaktgebiet einen n⁺-Polysiliziumkontakt enthält.

4. Verfahren nach Anspruch 3, worin das p-Dotierungsmittel Bor enthält.

5. Verfahren nach Anspruch 4, worin Bor mit einer Konzentration von etwa 1 x 10¹⁵ Ionen pro Quadratzentimeter und einer Energie von etwa 75.000 Elektronvolt implantiert wird.

6. Verfahren nach Anspruch 5, worin das n-Dotierungsmittel Arsen enthält.

7. Verfahren nach Anspruch 6, worin Arsen mit einer Konzentration von etwa 7,5 x 10¹⁵ Ionen pro Quadratzentimeter und einer Energie von etwa 50.000 Elektronvolt implantiert wird.

8. Verfahren nach Anspruch 7, mit dem das Glühen etwa 20 Minuten bei etwa 920 Grad Celsius in Stickstoff erfolgt.

## Revendications

1. Procédé pour la fabrication d'un dispositif semiconducteur muni d'un transistor bipolaire npn comprend les étapes suivantes:
- le dépôt d'une couche en silicium amorphe sur une couche en silicium monocristallin de type n dans laquelle doivent être formées une région de base et une région d'émetteur du transistor;
- l'implantation d'ions d'un agent de dopage de type p dans ladite couche en silicium amorphe pour établir un profil de concentration d'agents de dopage qui se situe au moins pratiquement dans ladite couche en silicium amorphe et qui présente une concentration de crête qui est relativement profonde dans ladite couche en silicium amorphe;
- l'implantation d'ions d'un agent de dopage de type n dans ladite couche en silicium amorphe pour établir un profil de concentration d'agents de dopage qui se situe au moins pratiquement dans ladite couche en silicium amorphe et qui présente une concentration de crête relativement peu profonde dans ladite couche en silicium amorphe;
- la réalisation de la configuration de ladite couche en silicium amorphe implantée et ensuite
- le recuit de la structure stratifiée pour provoquer la diffusion simultanée dudit agent de dopage de type p et dudit agent de dopage de type n à partir de ladite couche en silicium amorphe pour former dans ladite couche en silicium monocristallin une région de base de type p relativement profonde et une région d'émetteur de type n relativement peu profonde.

2. Procédé selon la revendication 1, selon lequel ladite couche en silicium amorphe est mise en configuration pour définir la région de contact d'émetteur dudit dispositif transistor.

3. Procédé selon la revendication 2, selon lequel, après recuit, ladite région de contact d'émetteur comporte un contact en polysilicium de type n⁺.

4. Procédé selon la revendication 3, selon lequel ledit agent de dopage est constitué par du bore.

5. Procédé selon la revendication 4, selon lequel du bore est implanté dans une concentration d'environ 1 x 10¹⁵ ions/cm² à une énergie d'environ 75.000 électrons-volts.

6. Procédé selon la revendication 5, selon lequel ledit agent de dopage de type n est constitué par de l'arsenic.

7. Procédé selon la revendication 7, selon lequel de l'arsenic est implanté dans une concentration d'environ 7,5 x 10¹⁵ ions/cm² à une énergie d'environ 50.000 électrons-volts.

8. Procédé selon la revendication 7, selon lequel le recuit s'effectue à environ 920°C dans de l'azote pendant environ 20 minutes.
